# FASCICULE DE BREVET EUROPEEN

(11) **EP 0 700 147 B1**
(45) Date de publication et mention de la délivrance du brevet: **11.06.1997**
(21) Numéro de dépôt: 95401681.2
(22) Date de dépôt: 12.07.1995
(51) Int. Cl.: H02M 7/00, H05K 7/14

(54) **Variateur électronique de vitesse**
Elektronischer Regelantrieb
Electronic variable-speed drive

(30) Priorité: 02.09.1994 FR 9410564
(43) Date de publication de la demande: 06.03.1996
(73) Titulaire: SCHNEIDER ELECTRIC SA, 92100 Boulogne Billancourt (FR)
(72) Inventeur: Guigueno, Hervé, F-94100 Saint Maur Des Fosses (FR)
(74) Mandataire: Saint Martin, René

(56) Documents cités:
- EP-A- 0 356 991
- EP-A- 0 449 640
- WO-A-94/14227
- GB-A- 2 271 679
- US-A- 4 908 738

## Description

La présente invention se rapporte à un variateur électronique de vitesse comprenant, dans un coffret, un redresseur alimenté en courant alternatif et associé des condensateurs pour alimenter, sous une tension continue, un onduleur constitué d'une pluralité de modules de puissance à interrupteurs statiques, avec un radiateur, contrôlés par un ensemble électronique de commande et délivrant une tension alternative.

Les variateurs électroniques de vitesse sont couramment utilisés en association avec des moteurs à courant continu ou à courant alternatif pour entraîner ces moteurs à vitesse variable.

Les variateurs de vitesse de type convertisseurs de fréquence fournissent, à partir du réseau alternatif monophasé ou triphasé, une tension alternative de valeur efficace et de fréquence variables suivant une loi préétablie, de manière à à contrôler la vitesse des moteurs alternatifs. Ces convertisseurs de fréquence comprennent essentiellement un redresseur qui associé à un filtre capacitif de lissage fournit une tension continue filtrée à un onduleur. Le redresseur est un pont redresseur alimenté par le réseau monophasé ou triphasé. L'onduleur fournit en sortie la tension alternative à fréquence variable. Des interrupteurs statiques appelés modules de puissance équipent cet onduleur qui est raccordé aux enroulements de phase du moteur et récrée, à partir de la tension continue fournie par le redresseur, une tension alternative. De tels variateurs sont connus par exemple par le document EP-A-0 356 991.

Les interrupteurs statiques de puissance sont commandés par une électronique de commande. Une technique de commande bien connue est appelée "Modulation de Largeur d'Impulsions" (en abrégé MLI- en anglais PWM pour Pulse Width Modulation). Le but de cette technique de commande est de générer une tension aussi proche que possible d'une sinusoïde.

Pour optimiser l'aération du variateur, le coffret présente une pluralité d'ouvertures. Lors d'un court-circuit, la déflagration qui se produit autour des modules de puissance provoque des courts-circuits sur les parties métalliques reliées à la terre.

La présente invention a pour objet de fournir une protection des modules de puissance capable d'éviter la propagation des flammes lors d'un incident affectant un ou plusieurs modules de puissance. La protection des modules de puissance ne modifie pas la compacité du variateur.

Le variateur électronique selon l'invention est caractérisé par le fait que les modules de puissance sont logés dans une enveloppe interne en matière plastique coopérant avec une carte de liaison électrique reliant électriquement les modules et les condensateurs et avec le radiateur, pour constituer une chambre non-étanche contenant lesdits modules de puissance.

Selon une caractéristique, l'enveloppe est constituée par une ceinture logée entre la carte de liaison électrique et le radiateur.

L'invention va maintenant être décrite avec plus de détail en se référant à un mode de réalisation donné à titre d'exemple et représenté par les dessins annexés sur lesquels:

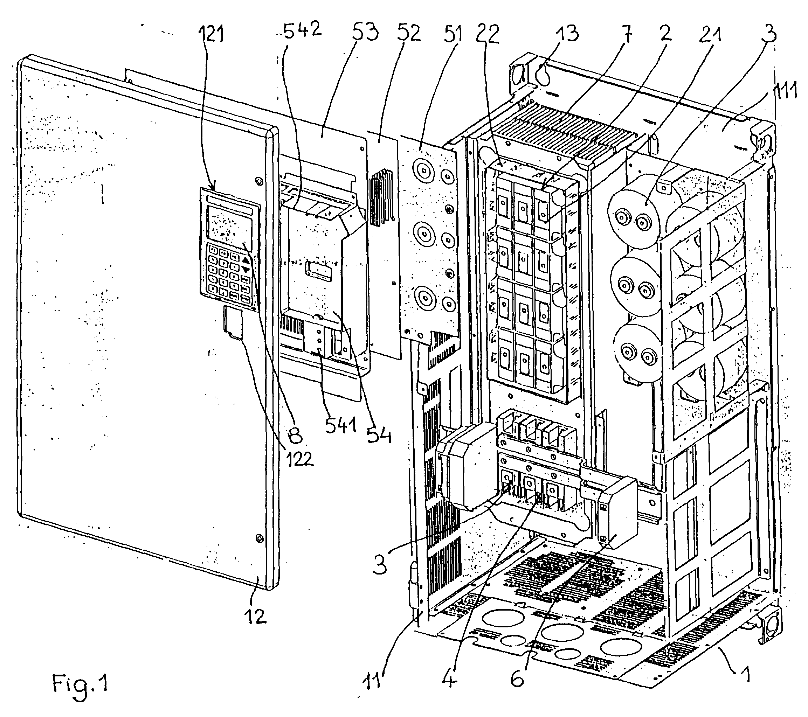

- la figure 1 est une vue en perspective éclatée d'un variateur électronique selon l'invention, le flanc gauche et le flanc supérieur étant enlevés;

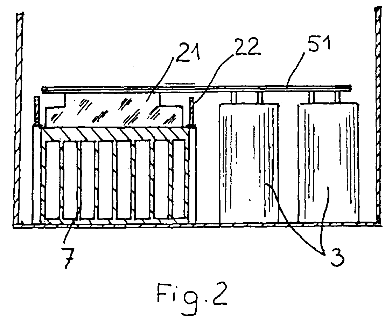

- la figure 2 est une vue de détail en coupe du logement des modules de puissance.

Le variateur électronique de vitesse représenté sur les dessins est un convertisseur de fréquence adapté à un moteur asynchrone.

Ce variateur électronique de vitesse présente un coffret 1 constitué par un corps de coffret 11 et par un couvercle 12 monté pivotant sur le corps de coffret à l'aide de charnières latérales. En position de fermeture, le couvercle se verrouille sur le corps de coffret.

Un bornier 6 monté dans le coffret sert à brancher, en entrée, le variateur avec le réseau et à brancher la sortie de l'onduleur au moteur.

Le coffret 11 se compose à l'arrière d'un fond métallique 111 pourvu, à l'arrière, de pattes de fixation 13 qui servent à la fixation du variateur sur un support. Des ouïes d'aération sont ménagées sur les différents flancs du coffret. Le flanc inférieur du coffret comporte une plaque passe-câbles servant à passer les câbles d'arrivée et de départ du bornier 6.

Le coffret 1 contient le redresseur à diodes 4, les condensateurs 3 et l'onduleur 2. L'onduleur est relié par les condensateurs 3 de filtrage au redresseur à diodes 4 qui est relié par l'intermédiaire du bornier 6 aux conducteurs de phase du réseau alternatif triphasé. Chaque bras de l'onduleur est équipé de deux interrupteurs statiques de puissance associés à des diodes de récupération. Ces ensembles de composants constituent les modules de puissance repérés 21. Les points milieux des couples d'interrupteurs sont reliés par des bornes du bornier 6 aux enroulements de phase du moteur.

Les interrupteurs statiques sont constitués par des composants MOS bipolaires tels que ceux connus sous la désignation IGBT, ou par des thyristors blocables du genre GTO ou par d'autres composants blocables analogues.

Les modules de puissance 21 se montent sur un refroidisseur 7 servant à refroidir les interrupteurs statiques de puissance. Ce refroidisseur 7 comporte, à l'arrière, des conduits servant à canaliser l'air. L'air est déplacé dans le refroidisseur 7 par un ventilateur, non représenté, puis est évacué à l'extérieur au travers des ouïes du flanc supérieur du coffret.

Une carte de liaison électrique 51 est montée au-dessus des modules de puissance 21 et des condensateurs 3 pour les relier électriquement. Cette carte conductrice 51, de conception connue, est constituée de conducteurs métalliques plans isolés entre-eux et isolés, extérieurement, par un revêtement en plastique.

Au-dessus de la carte de liaison électrique 51, se monte une carte de puissance 52 et une plaque-support 53 supportant un panier de contrôle 54 en matière plastique.

La carte de puissance 52 porte l'ensemble électronique de commande rapprochée des interrupteurs statiques.

Le panier de contrôle 54 cache les circuits électroniques de contrôle et protège l'opérateur contre les chocs électriques, lorsque le couvercle 12 est ouvert. Il porte des moyens de signalisation 541 visibles par une fenêtre 122 découpée du couvercle 12. Il présente une cuvette délimitée par un rebord fermé 542 qui reçoit la console de dialogue 8 tout en assurant l'étanchéité sur le pourtour de la fenêtre 121. Le panier de contrôle permet l'accès à des connecteurs (carte additionnelle, console de dialogue, carte PCMCIA, etc.) et présente des lumières pour le passage des connecteurs. Lorsque le couvercle 12 est ouvert, c'est le panier de protection 54 avec la plaque 53 qui ferme en grande partie le corps de coffret.

Le bornier 6 qui reste accessible au-dessous de la plaque 53 comporte des bornes protégées et l'ensemble est donc protégé.

Le variateur peut être paramétré par la console de dialogue 8 de type graphique qui affleure dans la fenêtre 121 du couvercle 12.

Les modules de puissance 22 sont logés dans une enveloppe interne 22 en matière plastique qui constitue une ceinture annulaire de protection les entourant. Cette ceinture 22 se loge entre la plaque conductrice 51 et le dessus du refroidisseur 7. Le périmètre de la ceinture qui présente une section rectangulaire est assez proche de celui des modules et ne dépasse pas le refroidisseur. La fixation de cette ceinture est assurée par la plaque 53.

Il est bien entendu que l'on peut sans sortir du cadre de l'invention imaginer des variantes et des perfectionnements de détail et de même envisager l'emploi de moyens équivalents.

Le dispositif qui vient d'être décrit ci-dessus peut s'appliquer à tout variateur de vitesse électronique.

## Revendications

1. Variateur électronique de vitesse comprenant, dans un coffret (1), un redresseur (4) alimenté en courant alternatif et associé des condensateurs (3) pour alimenter, sous une tension continue, un onduleur (2) constitué d'une pluralité de modules de puissance (21) à interrupteurs statiques, avec un radiateur, contrôlés par un ensemble électronique de commande (52) et délivrant une tension alternative, caractérisé par le fait que les modules de puissance (21) sont logés dans une enveloppe interne (22) en matière plastique coopérant avec une carte de liaison électrique (51) reliant électriquement les modules (21) et les condensateurs (3) et avec le radiateur (7), pour constituer une chambre non étanche contenant lesdits modules de puissance (51).

2. Variateur selon la revendication 1, caractérisé par le fait que l'enveloppe (22) est constituée par une ceinture logée entre la carte de liaison électrique (51) et le radiateur (7).

## Patentansprüche

1. Elektronischer Regelantrieb, bestehend aus, in einem Gehäuse (1), einer Gleichrichtenröhre (4) die mit Wechselstrom versorgt wird und mit Kondensatoren (3) verbunden ist, um einen Wechselrichter (2) mit Gleichspannung zu versorgen, der aus einer Vielzahl von Leistungsmodulen (21) mit statischen Unterbrechen gebildet ist, die von einer elektronischen Steueranlage (52) gesteuert werden und eine Wechselspannung abgeben, dadurch gekennzeichnet, daß die Leistungensmodule (21) in einer inneren Hülle (22) aus Plastik eingebettet sind, die mit einer elektrischen Verbindungskarte (51), die die Module (21) und die Kondensatoren (3) elektrisch verbindet, und mit dem Abstrahlblech (7) zusammenwirkt, um eine undichte Kammer zu erstellen, die die Leistungsmodule (51) enthält.

2. Regelantrieb laut Patentanspruch 1, dadurch gekennzeichnet, daß die Hülle (22) aus einem Gürtel besteht, der zwischen der elektrischen Verbindungskarte (51) und dem Abstrahlblech (7) gelagert ist.

## Claims

1. Electronic variable speed drive including, in a casing (1), a rectifier (4) supplied with alternating current and associated with capacitors (3) to supply a DC voltage to an inverter (2) made up of a plurality of solid-state switch power modules (21) controlled by an electronic control system (52) and producing an AC voltage, characterised in that the power modules (21) are accommodated in a plastics material internal enclosure (22) cooperating with an electric connection board (51) electrically connecting the modules (21) and the capacitors (3) and with the heatsink (7), to constitute a non-sealed chamber containing said power modules (51).

2. Variable speed drive according to claim 1 characterised in that the enclosure (22) is an open-ended box-section disposed between the electrical connection board (51) and the heatsink (7).
